(19)

Europäisches
Patentamt
European
Patent Office
Office européen
des brevets

(11) **EP 1 757 165 B1**

(12) **EUROPEAN PATENT SPECIFICATION**

(45) Date of publication and mention
of the grant of the patent:
**28.12.2011 Bulletin 2011/52**

(51) Int Cl.:
***G10L 19/00*** (2006.01)

(21) Application number: **05744006.7**

(22) Date of filing: **03.06.2005**

(86) International application number:
**PCT/IB2005/051820**

(87) International publication number:
**WO 2005/122640 (22.12.2005 Gazette 2005/51)**

(54) **CODING REVERBERANT SOUND SIGNALS**

KODIERUNG VON TONSIGNALEN MIT HALL

CODAGE DE SIGNAUX ACOUSTIQUES REVERBERES

(84) Designated Contracting States:
**AT BE BG CH CY CZ DE DK EE ES FI FR GB GR
HU IE IS IT LI LT LU MC NL PL PT RO SE SI SK TR**

(30) Priority: **08.06.2004 EP 04102582**

(43) Date of publication of application:
**28.02.2007 Bulletin 2007/09**

(73) Proprietor: **Koninklijke Philips Electronics N.V.
5621 BA Eindhoven (NL)**

(72) Inventors:
- **VAN SCHIJNDEL, Nicolle, H.
  NL-5656 AA Eindhoven (NL)**
- **GERRITS, Andreas, J.
  NL-5656 AA Eindhoven (NL)**
- **BOSCARINO, Corrado
  NL-5656 AA Eindhoven (NL)**

(74) Representative: **Damen, Daniel Martijn et al
Philips
Intellectual Property & Standards
P.O. Box 220
5600 AE Eindhoven (NL)**

(56) References cited:
**WO-A-03/007656       WO-A-03/085645**

- **UNOKI M ET AL: "A method based on the MTF
  concept for dereverberating the power envelope
  from the reverberant signal" 2003 IEEE
  INTERNATIONAL CONFERENCE ON
  ACOUSTICS, SPEECH, AND SIGNAL
  PROCESSING (CAT. NO.03CH37404) IEEE
  PISCATAWAY, NJ, USA, vol. 1, 2003, pages
  888-891, XP002343755 ISBN: 0-7803-7663-3 cited
  in the application**
- **MASASHI UNOKI ET AL: "A speech
  dereverberation method based on the MTF
  concept", EUROSPEECH 2003, 1 September 2003
  (2003-09-01), pages 1417-1420, XP007006944,**

## Description

The invention relates to the field of audio signal coding. Especially, the invention relates to the field of efficient coding of reverberant audio signals. The invention relates to an encoder, a decoder, methods for encoding and decoding, an encoded audio signal, storage media with data representing such encoded signal, and audio devices with an encoder and/or decoder.

Reverberation is caused by the acoustics of the environment, e.g. a concert hall, in which the sound is recorded. It consists of the reflections against surfaces in this environment. As a result, the recorded sound signal does not only contain the direct "dry" audio signal, but also a series of delayed and attenuated reflections. I.e. the reverberation component consists of delayed and attenuated versions of the direct "dry" sound and, as a result, the reverberant component is correlated with the direct signal. Here, "dry" means "anechoic", i.e. containing substantially no echos or reverberation.

Patent Cooperation Treaty Patent Application Publication WO-A1-03/007656 discloses a system of encoding a stereo signal as a mono signal and associated stereo parameters.

The article "A speech dereverberation method based on the MTF concept", Unoki et al, Eurospeech 2003, discloses dereverberation of a speech signal.

Experiments show that some non-transparent sound codecs do not function properly by coding sound signals with a significant amount of reverberation, i.e. the codecs produce sound signals with clearly audible artefacts. However, the same sound codec may perform well on sound signals with very or purely "dry" signals, i.e. sound signals recorded in an anechoic environment or artificially created sounds without reverberation added.

In many applications, reverberation is considered a negative characteristic of the sound signal. For example, the performance of automatic speech recognition systems degrades when the speech contains reverberation, and, in communication applications, reverberation negatively affects the intelligibility and quality of the speech. A solution to this problem may be to remove the reverberation from the signal, i.e., to de-reverberate, and this is also done in some systems (Basbug et al., 2003) - see the list of references.

In high-quality audio coding, however, the situation is different. Audio coding strives for transparency, and therefore the reverberation needs to be coded as well. Moreover, in music the reverberation component is an important part of the signal and audio signals with this component are preferred to signals without it, which sound "dry" or dull, and the sound lacks the significant individual character of the recording environment.

To the knowledge of the inventors in the prior art no special precautions are taken to code the reverberation component of sound signals and this may lead to quality problems.

It may be seen as an object of the present invention to provide a method and an audio encoder and decoder capable of handling reverberant audio signals in high quality by using audio codecs.

According to a first aspect of the invention, this object is complied with by providing an audio encoder as set forth in claim 1.

The separation means serves to split the audio signal into an anechoic, i.e. "dry", part and into information regarding reverberant aspects related to the audio signal. In other words, the audio signal is de-reverberated, and information describing a reverberant field associated with the audio signal is extracted, i.e. information enabling a substantially transparent recreation of the reverberance.

The encoder means handles the "dry" part and the reverberant part separately. Thus, it is possible to apply an audio codec for encoding the "dry" part to the first encoded signal part, while the reverberation part may be encoded according to completely different algorithms suited to describe reverberation, such as a parametric description sufficiently precise to substantially recreate the reverberation part of the signal at the encoder.

This relieves the audio codec from the task of coding the reverberation component, solving the problem of coding reverberant sound signals. Instead, means for encoding a reverberant part of the reverberant audio signal may comprise reverberation algorithms based on a parametric description of the reverberant part of the original audio signal such using a very limited number of parameters. As an effect, a parametric codec may be used solely for encoding a "dry" signal, which such codec is well suited for. Hereby it is possible to substantially transparently encode and decode a reverberant audio signal using an audio codec in combination with means for encoding a reverberant part of the reverberant audio signal.

In addition, encoding efficiency is increased compared to encoding a reverberant sound signal directly. This is due to the fact that an encoder according to the first aspect exploits the correlation introduced in the sound signal by the reverberant field to the maximum, resulting in higher coding efficiency. I.e. redundancy in the reverberant part is taken into account specifically.

The encoder means is adapted to encode the substantially anechoic audio signal according to a parametric audio codec. e.g. (Schuijers et al., 2003). In a preferred embodiment, the separation means is adapted to apply Unoki's de-reverberation algorithm to the audio signal so as to separate it into the substantially anechoic part and the information describing the reverberant field. By Unoki's de-reverberation algorithm is understood the de-reverberation principles described in: M. Unoki, M. Furukawa, K. Sakata, and M. Akagi, "A Method based on the MTF Concept for dereverberating the Power Envelope from the Reverberant Signal," in Proc. IEEE Int. Conf. on Acoust., Speech, Signal Processing, Hong Kong, China, April 6-19, Vol. I, pp. 840- 843, 2003.

A second aspect of the invention provides an audio decoder as set forth in claim 2.

Thus, the audio decoder according to the second aspect is adapted to decode an encoded signal from the audio encoder according to the first aspect and thus form an encoder/decoder system.

In the decoder means the "dry" signal is reconstructed. Reverberance is then added to the "dry" signal by the transforming means based on the reverberation information. This is known from existing artificial reverberation generators or room simulators that are able to produce high audio quality reverberation based on few parameters. An extra advantage of this method, i.e., addition of reverberation in the decoder, is that the reverberance masks some potential artefacts in the decoded "dry" signal.

Preferably, the transforming means comprises means for convoluting the regenerated anechoic audio signal with an impulse response h(t) being a function of time t, wherein h(t) is based on the second encoded signal part.

Preferably, the second encoded signal part comprises a representation of

- a first parameter T related to a reverberation time of the audio signal, and
- a second parameter A related to a reverberation amplitude of the audio signal.

The decoder means may be adapted to decode the first encoded signal part according to a parametric audio codec.

In a third aspect the invention provides a method of encoding an audio signal, as set forth in claim 6.

In a fourth aspect the invention provides a method of decoding an encoded audio signal as set forth in claim 7.

In a fifth aspect the invention provides an encoded audio signal as set forth in claim 8.

The encoded signal may be a digital electrical signal with a format according to standard digital audio formats. The signal may be transmitted using an electrical connecting cable between two audio devices. However, the encoded signal could be a wireless signal, such as an air-borne signal using a radio frequency carrier, or it may be an optical signal adapted for transmission using an optical fiber.

In a sixth aspect the invention provides a storage medium comprising data representing an encoded audio signal according to the fifth aspect. The storage medium is preferably a standard audio data storage medium such as DVD, CD, read-writable CD, minidisk, MP3 disc, compact flash, memory stick etc. However, it may also be a computer data storage medium such as a computer harddisk, a computer memory, a floppy disk etc.

In a seventh aspect the invention provides an audio device comprising an audio encoder according to the first aspect.

In an eighth aspect the invention provides an audio device comprising an audio decoder according to the second aspect.

Preferred audio devices according to the seventh and eighth aspects are all different types of tape, disk, or memory based audio recorders and players. For example: MP3 players, DVD players, audio processors for computers etc. In addition, it may be advantageous for mobile phones.

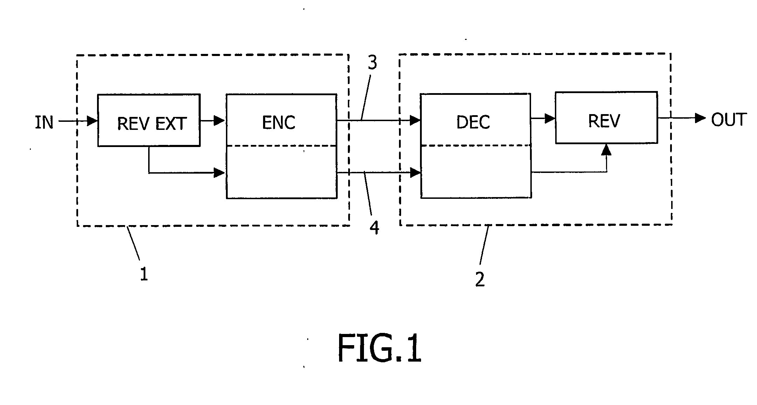

In the following the invention is described in more details with reference to the accompanying Fig. 1 illustrating a block diagram of a preferred encoder and decoder according to the invention.

While the invention is susceptible to various modifications, specific embodiments have been shown by way of example in the drawing and will be described in detail herein. It should be understood, however, that the invention is not intended to be limited to the particular forms disclosed. Rather, the invention is to cover all modifications falling within the scope of the invention as defined by the appended claims.

Figure 1 shows a block diagram illustrating the principles of a preferred embodiment of an encoder 1 and decoder 2 with respect to signal flow.

An audio signal is received at an input IN of the encoder 1. First, the audio signal is handled by a reverberation extractor REV EXT. Here, the audio signal is de-reverberated using Unoki's de-reverberation algorithm (Unoki et al., 2003). It should be noted that for monaural signals, it is not trivial to extract the reverberation component from a reverberant audio signal. However, this extraction does not have to be perfect and a gain may already be obtained by removing part of the reverberant field. For multi-channel signals already good de-reverberation algorithms exist.

The resulting "dry" signal is then encoded in an SSC encoder part of the encoder means ENC such as described in (Schuijers et al., 2003); while another part of the encoder means ENC encodes the reverberant part extracted by the reverberation extractor REV EXT. Output from the encoder 1 has two parts: a first part being a bit stream 3 provided by the SSC encoder part of the encoder means ENC, and a second part comprising two reverberation parameters 4 provided by the reverberation extractor REV EXT, i.e. a parameter description of the removed reverberation part of the original audio signal. Preferably, the two reverberation parameters 4 are the reverberation time $T_R$, and a reverberation amplitude constant A, associated with a level of the reverberation part of the original audio signal relative to the "dry" part of the audio signal, being a very brief description of the room reverberation impulse response h(t). One could also send the complete room reverberation impulse response h(t) in the beginning of the signal, with updates during the signal when needed; this is also efficient, because h(t) usually varies slowly or not at all. The encoder part of the encoder means ENC that encodes the reverberant part highly depends on the actual form of the reverberant part delivered by the reverberation extractor REV EXT. In case the reverberation extractor REV EXT delivers only a few reverberation parameters, encoding of the reverberation part can be said to be included in the extraction itself, and thus the encoder means ENC may not need to add further encoding to the reverberation part received from the reverberation extractor REV EXT.

The decoder 2 receives the SSC encoded signal 3 and the two reverberation parameters 4 from the encoder 1. It is to be understood that the Fig. 1 merely illustrates the principles of an encoder/decoder system. The encoded signals 3, 4, or data representing these signals 3, 4, may typically be stored on a data carrier or storage medium, such as an audio disk for a MP3 player etc.

In the decoder 2 the SSC encoded signal 3 is decoded by a SSC decoder part of the decoder means DEC thus restoring the substantially "dry" audio signal. This restored "dry" signal is then fed to a reverberation processor REV. The reverberation processor REV also receives the two reverberation parameters 4 that have been decoded by another part of the decoder means DEC, and based on these parameters 4, the reverberation processor REV generates an impulse response based on the extracted reverberation information in the two reverberation parameters 4, i.e. a room impulse response is constructed based on the two reverberation parameters 4. The reverberation part of the original audio signal is applied to the restored "dry" audio signal from the SSC decoder part of the decoder means DEC by convolution with the generated reverberation impulse response. The restored "dry" audio signal is thus transformed into a restored, or at least substantially restored, original audio signal. Finally, this restored original audio signal is the provided at an output OUT of the encoder 2.

The room reverberation impulse response h(t), where t denotes time, generated in the reverberation processor REV is preferable of the form:

$$h(t) = A*\exp(-6.9\ t/T_R)*n(t),$$

in which n(t) is a white noise signal.

In principle the invention can be used in connection with any audio encoder, e.g. the SSC encoder as mentioned described in (Schuijers et al., 2003), which is currently being standardised in MPEG, and with any de-reverberation algorithm.

Encoders and decoders according to the invention may be implemented on a single chip with a digital signal processor. The chip can then be applied built into audio devices independent on signal processor capacities of such devices. The encoders and decoders may alternatively be implemented purely by algorithms running on a main signal processor of the application device.

In the claims reference signs to the figures are included for clarity reasons only. These references to exemplary embodiments in the figures should not in any way be construed as limiting the scope of the claims.

LIST OF REFERENCES:

F. Basbug, K. Swaminathan, and S. Nandkumar, "Noise Reduction and Echo Cancellation Front-End for Speech Codecs," IEEE Transactions on Speech and Audio Processing, vol. 11, no.1, 2003.

E. Schuijers, W. Oomen, B. den Brinker, J. Breebaart, "Advances in Parametric Coding for High-Quality Audio," in Proc. of the 114th AES Convention 2003 March 22-25 Amsterdam, The Netherlands, 2003.

M. Unoki, M. Furukawa, K. Sakata, and M. Akagi, "A Method based on the MTF Concept for dereverberating the Power Envelope from the Reverberant Signal," in Proc. IEEE Int. Conf. on Acoust., Speech, Signal Processing, Hong Kong, China, April 6-19, Vol. I, pp. 840- 843, 2003.

## Claims

1. An audio encoder (1) adapted to encode an audio signal, the audio encoder (1) **characterized by** comprising:

   - separation means adapted to separate the audio signal into a substantially anechoic audio signal and information describing a reverberant field associated with the audio signal,
   - encoder means adapted to encode the substantially anechoic audio signal into a first encoded signal part (3) and encode the information describing the reverberant field into a second encoded signal part (4), wherein

   the encoder means is adapted to encode the substantially anechoic audio signal according to a parametric audio codec.

2. An audio decoder (2) adapted to regenerate an audio signal from an encoded audio signal representing an original audio signal, the encoded audio signal comprising a first part (3) representing a substantially anechoic part of the original audio signal and a second part (4) representing information about a reverberant field associated with the original audio signal, comprising:

   - decoder means adapted to decode the first encoded signal part (3) into a substantially anechoic audio signal, wherein the decoder means is adapted to decode the first encoded signal part (3) according to a parametric audio codec, the decoder means further being adapted to generate from the second encoded signal part (4) the information describing the reverberant field associated with the audio signal, and
- transforming means adapted to add reverberance to the substantially anechoic audio signal based on the information describing the reverberant field.

3. Audio decoder (2) according to claim 2 , wherein the transforming means comprises means for convoluting the substantially anechoic audio signal with an impulse response h(t) being a function of time t, wherein h(t) is based on the information describing the reverberant field.

4. Audio decoder (2) according to claim 3 , wherein the decoder means is adapted to generate from the second encoded signal part (4)

- a first parameter T related to a reverberation time of the audio signal, and
- a second parameter A related to a reverberation amplitude of the audio signal.

5. Audio decoder (2) according to claim 4 , wherein the transforming means is adapted to calculate said impulse response h(t) based on said first and second parameters as $h(t) = A*exp(k*t/T)*n(t)$, wherein k represents a constant and n(t) represents a noise signal.

6. A method of encoding an audio signal, **characterized by** comprising the steps of:

- separating the audio signal into a substantially anechoic part and information describing a reverberant field associated with the audio signal,
- encoding the substantially anechoic part of the audio signal into a first encoded signal part (3) according to a parametric audio codec;
- encoding the information describing the reverberant field into a second encoded signal part (4).

7. A method of decoding an encoded audio signal representing an original audio signal, the encoded audio signal comprising a first part (3) representing a substantially anechoic part of the original audio signal and a second part (4) representing information about a reverberant field associated with the original audio signal, comprising the steps of:

- decoding the first part into a first audio signal according to a parametric audio codec,
- decoding the second part into information describing the reverberant field associated with the original audio signal, and
- transforming the first audio signal by adding reverberation based on the information describing the reverberant field so as to regenerate the original audio signal.

8. Encoded audio signal (3, 4) representing an original audio signal, the encoded signal (3, 4) comprising:

- a first part (3) representing according to a parametric audio codec, a substantially anechoic part of the original audio signal, **characterized by**
- a second part (4) representing information about a reverberant field associated with the original audio signal.

9. A storage medium comprising data representing an encoded audio signal (3, 4) according to claim 8.

10. Audio device comprising an audio encoder (1) according to claim 1.

11. Audio device comprising an audio decoder (2) according to claim 2.

**Patentansprüche**

1. Audiocodierer (1), vorgesehen zum Codieren eines Audiosignals, wobei der Audiocodierer (1) **dadurch gekennzeichnet ist, dass** dieser Folgendes enthält:

- Trennmittel, vorgesehen zum Aufteilen des Audiosignals in ein im Wesentlichen echoloses Audiosignal und Information, die ein mit dem Audiosignal assoziiertes Hallfeld beschreibt,
- Codiermittel, vorgesehen zum Codieren des im Wesentlichen echolosen Teils des Audiosignals in einen ersten codierten Signalteil (3) und zum Codieren der Information, die das Hallfeld beschreibt, in einen zweiten codierten Signalteil (4), wobei das Codiermittel dazu vorgesehen ist, das im Wesentlichen echolose Audiosignal entsprechend einem parametrischen Audiocodec zu codieren.

2. Audiodecoder (2), vorgesehen zum Regenerieren eines Audiosignals aus einem codierten Audiosignal, das ein originales Audiosignal darstellt, wobei das codierte Audiosignal einen ersten Teil (3) aufweist, der einen im Wesentlichen echolosen Teil des ursprünglichen Audiosignals darstellt, und einen zweiten Teil (4), der Information über ein mit dem ursprünglichen Audiosignal assoziiertes Hallfeld darstellt, wobei dieser Decoder Folgendes umfasst:

- Decodermittel, vorgesehen zum Decodieren des ersten codierten Signalteils (3) in ein im Wesentlichen echoloses Audiosignal, wobei das Decodermittel dazu vorgesehen ist, den ersten codierten Signalteil (3) entsprechend einem parametrischen Audiocodec zu decodieren, wobei das Decodermittel weiterhin dazu vorgesehen ist, aus dem zweiten codierten Signalteil (4) die Information zu erzeugen, die das mit dem Audiosignal assoziierte Hallfeld beschreibt, und

- Transformationsmittel, vorgesehen zum Hinzufügen von Hall zu dem im Wesentlichen echolosen Audiosignal, und zwar auf Basis der Information, die das Hallfeld beschreibt.

3. Audiodecoder (2) nach Anspruch 2, wobei das Transformationsmittel Mittel zum Zusammenfalten des im Wesentlichen echolosen Audiosignals mit einer Impulsantwort h(t), die eine Funktion der Zeit t ist, wobei h(t) auf der Information basiert, die das Hallfeld beschreibt.

4. Audiodecoder (2) nach Anspruch 3, wobei das Decodermittel dazu vorgesehen ist, aus dem zweiten codierten Signalteil (4) Folgendes zu erzeugen:

- einen ersten Parameter T in Bezug auf eine Hallzeit des Audiosignals, und
- einen zweiten Parameter A in Bezug auf eine Hallamplitude des Audiosignals.

5. Audiodecoder (2) nach Anspruch 4, wobei das transformationsmittel dazu vorgesehen ist, die genannte Impulsantwort h(t) auf Basis des genannten ersten und zweiten Parameters als $h(t) = A \cdot \exp(k \cdot t / T) \cdot n(t)$ zu berechnen, wobei k eine Konstante und n(t) ein Rauschsignal darstellt.

6. Verfahren zum Codieren eines Audiosignals, **dadurch gekennzeichnet, dass** dieses Verfahren die nachfolgenden Verfahrensschritte umfasst:

- das Aufteilen des Audiosignals in einen im Wesentlichen echolosen Teil und in Information, die ein mit dem Audiosignal assoziiertes Hallfeld beschreibt,
- das Codieren des im Wesentlichen echolosen Teils des Audiosignals in einen ersten codierten Signalteil (3) entsprechend einem parametrischen Audiocodec;
- das Codieren der Information, die das Hallfeld beschreibt, in einen zweiten codierten Signalteil (4).

7. Verfahren zum Decodieren eines codierten Audiosignals, das ein originales Audiosignal darstellt, wobei das codierte Audiosignal einen ersten Teil (3) aufweist, der einen im Wesentlichen echolosen Teil des ursprünglichen Audiosignals darstellt, sowie einen zweiten Teil (4), der Information über ein mit dem ursprünglichen Audiosignal assoziiertes Hallfeld darstellt, wobei das Verfahren die nachfolgenden Verfahrensschritte umfasst:

- das Decodieren des ersten Teils in ein erstes Audiosignal entsprechend einem parametrischen Audiocodec,
- das Decodieren des zweiten Teils in Information, die das mit dem ursprünglichen Audiosignal assoziierte Hallfeld beschreibt, und
- das Transformieren des ersten Audiosignals durch Hinzufügung von Hall auf Basis der Information, die das Hallfeld beschreibt, und zwar zum Regenerieren des ursprünglichen Audiosignals.

8. Codiertes Audiosignal (3, 4) das ein ursprüngliches Audiosignal darstellt, wobei das codierte Signal (3, 4) Folgendes umfasst:

- einen ersten Teil (3), der entsprechend einem parametrischen Audiocodec einen im Wesentlichen echolosen Teil des ursprünglichen Audiosignals darstellt, **gekennzeichnet durch**
- einen zweiten Teil (4), der Information über ein mit dem ursprünglichen Audiosignal assoziiertes Hallfeld darstellt.

9. Speichermedium mit Daten, die ein codiertes Audiosignal (3, 4) nach Anspruch 8 darstellen.

10. Audioanordnung mit einem Audiocodierer (1) nach Anspruch 1.

11. Audioanordnung mit einem Audiodecoder (2) nach Anspruch 2.

## Revendications

1. Codeur audio (1) qui est adapté de manière à coder un signal audio, le codeur audio (1) étant **caractérisé en ce qu'**il comprend :

- des moyens de séparation qui sont adaptés de manière à séparer le signal audio en un signal audio sensiblement anéchoïque et en information qui décrit un champ réverbérant étant connexe au signal audio,
- des moyens de codage qui sont adaptés de manière à coder le signal audio sensiblement anéchoïque en une première partie de signal codé (3) à coder l'information qui décrit le champ réverbérant en une seconde partie de signal codé (4), dans lequel : les moyens de codage sont adaptés de manière à coder le signal audio sensiblement anéchoïque selon un codeur/décodeur audio paramétrique.

2. Décodeur audio (2) qui est adapté de manière à régénérer un signal audio à partir d'un signal audio codé qui représente un signal audio original, le signal audio codé comprenant une première partie (2) qui représente une partie sensiblement anéchoïque du signal audio original et une seconde partie (4) qui représente de l'information relative à un champ réverbérant étant connexe au signal audio original, comprenant :

- des moyens de décodage qui sont adaptés de manière à décoder la première partie de signal codé (3) en un signal audio sensiblement anéchoïque, dans lequel les moyens de décodage sont adaptés de manière à décoder la première partie de signal codé (3) selon un codeur/décodeur audio paramétrique, les moyens de décodage étant en outre adaptés de manière à générer à partir de la seconde partie de signal codé (4) l'information qui décrit le champ réverbérant étant connexe au signal audio, et

- des moyens de transformation qui sont adaptés de manière ajouter une réverbération au signal audio sensiblement anéchoïque sur la base de l'information qui décrit le champ réverbérant.

**3.** Décodeur audio (2) selon la revendication 2, dans lequel les moyens de transformation comprennent des moyens pour la convolution du signal audio sensiblement anéchoïque avec une réponse impulsionnelle h(t) étant une fonction du temps t, dans lequel h(t) est basée sur l'information qui décrit le champ réverbérant.

**4.** Décodeur audio (2) selon la revendication 3, dans lequel les moyens de décodage sont adaptés de manière à générer à partir de la seconde partie de signal codé (4) :

- un premier paramètre T qui se rapporte à un temps de réverbération du signal audio, et
- un second paramètre A qui se rapporte à une amplitude de réverbération du signal audio.

**5.** Décodeur audio (2) selon la revendication 4, dans lequel les moyens de transformation sont adaptés de manière à calculer ladite réponse impulsionnelle h(t) sur la base desdits premier et second paramètres en tant que $h(t) = A*exp(k*t/T)*n(t)$ où k représente une constante et où n(t) représente un signal de bruit.

**6.** Procédé de codage d'un signal audio, **caractérisé en ce qu'**il comprend les étapes suivantes consistant à :

- séparer le signal audio en une partie sensiblement anéchoïque et en information qui décrit un champ réverbérant étant connexe au signal audio ;
- coder la partie sensiblement anéchoïque du signal audio en une première partie de signal codé (3) selon le codeur/décodeur audio paramétrique ; et
- coder l'information qui décrit le champ réverbérant en une seconde partie de signal codé (4).

**7.** Procédé de décodage d'un signal audio codé représentant un signal audio original, le signal audio codé comprenant une première partie (3) qui représente une partie sensiblement anéchoïque du signal audio original et une seconde partie (4) qui représente de69+- l'information relative à un champ réverbérant étant connexe au signal audio original, comprenant les étapes suivantes consistant à :

- décoder la première partie en un premier signal audio selon un codeur/décodeur audio paramétrique ;
- décoder la seconde partie en information qui décrit le champ réverbérant étant connexe au signal audio original ; et
- transformer le premier signal audio en ajoutant une réverbération sur la base de l'information qui décrit le champ réverbérant de manière à régénérer le signal audio original.

**8.** Signal audio codé (3, 4) représentant un signal audio original, le signal codé (3, 4) comprenant :

- une première partie (3) représentant, selon un codeur/décodeur audio paramétrique, une partie sensiblement anéchoïque du signal audio original, ce qui est **caractérisé par** :
- une seconde partie (4) représentant de l'information relative à un cham réverbérant étant connexe au signal audio original.

**9.** Support de stockage comprenant des données qui représentent un signal audio codé (3, 4) selon la revendication 8.

**10.** Dispositif audio comprenant un codeur audio (1) selon la revendication 1.

**11.** Dispositif audio comprenant un décodeur audio (2) selon la revendication 2.

FIG.1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 03007656 A1

**Non-patent literature cited in the description**

- **UNOKI et al.** A speech dereverberation method based on the MTF concept. *Eurospeech,* 2003
- **M. UNOKI ; M. FURUKAWA ; K. SAKATA ; M. AKAGI.** A Method based on the MTF Concept for dereverberating the Power Envelope from the Reverberant Signal. *Proc. IEEE Int. Conf. on Acoust., Speech, Signal Processing,* 06 April 2003, vol. I, 840-843
- **F. BASBUG ; K. SWAMINATHAN ; S. NANDKUMAR.** Noise Reduction and Echo Cancellation Front-End for Speech Codecs. *IEEE Transactions on Speech and Audio Processing,* 2003, vol. 11 (1
- **E. SCHUIJERS ; W. OOMEN ; B. DEN BRINKER ; J. BREEBAART.** Advances in Parametric Coding for High-Quality Audio. *Proc. of the 114th AES Convention,* 22 March 2003